# FASCICULE DE BREVET EUROPEEN

(11) **EP 1 876 601 B1**
(45) Date de publication et mention de la délivrance du brevet: **01.06.2011**
(21) Numéro de dépôt: 07111495.3
(22) Date de dépôt: 02.07.2007
(51) Int. Cl.: G11C 11/406

(54) **Procédé de rafraîchissement d'une mémoire vive dynamique, en particulier en mode veille et en mode de fonctionnement actif, et dispositif de mémoire vive dynamique correspondant, par exemple incorporé dans un téléphone mobile cellulaire**
Verfahren zum Auffrischen eines dynamischen Schreib-Lese-Speichers, insbesondere im Bereitschaftsmodus und im aktiven Betriebsmodus, und entsprechende dynamische Schreib-Lese-Speichervorrichtung, beispielsweise in ein Mobiltelefon integriert
Method for refreshing a dynamic RAM, in particular in standby mode and in active operation mode, and corresponding dynamic RAM device, for example incorporated in a cellular mobile telephone

(30) Priorité: 03.07.2006 FR 0605990
(43) Date de publication de la demande: 09.01.2008
(73) Titulaire: STMicroelectronics SA, 92120 Montrouge (FR)
(72) Inventeur: Harrand, Michel, 38120 Saint Egrève (FR)
(74) Mandataire: Zapalowicz, Francis

(56) Documents cités:
- EP-A- 1 796 102
- EP-A1- 0 917 152
- US-A- 4 292 676
- US-A- 5 629 898
- US-A- 6 094 705
- US-A- 6 167 484
- US-A1- 2004 218 439
- US-A1- 2005 030 806
- US-A1- 2005 169 083

## Description

L'invention concerne les mémoires vives dynamiques, c'est-à-dire nécessitant un rafraîchissement périodique des données que contiennent les cellules-mémoire de ces mémoires. Et, l'invention concerne plus particulièrement le rafraîchissement de ces mémoires vives dynamiques.

L'invention s'applique avantageusement, mais non limitativement, aux téléphones mobiles cellulaires qui incorporent des mémoires vives dynamiques.

Les téléphones mobiles cellulaires de troisième génération nécessitent l'intégration de grandes quantités de mémoires. Cependant, le coût du produit doit rester faible. L'utilisation de mémoires vives dynamiques (DRAM) à la place des mémoires vives statiques (SRAM) utilisées aujourd'hui, permet cet accroissement de capacité de mémoire pour un faible coût.

Cependant, une contrainte importante dans ce type d'application, est la faible consommation électrique lorsque le téléphone est en mode « veille » ou en fonctionnement actif, afin de ne pas décharger les batteries trop vite. Or, si les mémoires vives dynamiques ont un courant de fuite statique plus faible que les mémoires vives statiques, elles nécessitent en revanche d'être continuellement rafraîchies, en particulier si l'on doit conserver les données en mode « veille ». Et, ce rafraîchissement nécessite une consommation d'énergie qu'il importe de minimiser. La fréquence de rafraîchissement est donnée par le nombre de pages-mémoire à rafraîchir et par le temps de rétention de la mémoire. Ce temps de rétention est essentiellement lié aux fuites de jonction des transistors des cellules-mémoire.

Une demande de brevet au nom de la demanderesse déposée le même jour ayant pour titre « Procédé de rafraîchissement d'une mémoire vive dynamique et dispositif de mémoire vive dynamique correspondant, en particulier incorporé dans un téléphone mobile cellulaire », présente une solution consistant à mesurer continuellement le temps de rétention de toutes les cellules-mémoire de la mémoire et d'ajuster la période de rafraîchissement en conséquence. Plus concrètement, de façon à savoir s'il est possible de diminuer la période de rafraîchissement, le procédé consiste à rafraîchir moins souvent une cellule-mémoire choisie et de regarder le nombre d'erreurs provoqué par un rafraîchissement des données moins fréquent.

En outre, dans la demande précitée, du fait de l'incorporation dans la mémoire dynamique d'un système de correction d'erreurs, ne sera pris en compte qu'un nombre d'erreurs supérieur au nombre d'erreurs que pourra corriger le système de correction d'erreur par paquet (ou mot) de cellules-mémoire, en fonction de l'ECC utilisé (« Error Correcting Code » ou ECC en langue anglaise).

En effet, tout système de correction d'erreurs est capable de corriger un nombre donné d'erreurs au sein d'un paquet de cellules-mémoire.

Cependant, si le procédé décrit ci-dessus permet de diminuer la fréquence de rafraîchissement en mode veille de l'appareil incorporant ladite mémoire dynamique, il n'est pas utilisable dans le mode de fonctionnement actif de l'appareil.

Par ailleurs, le procédé de la demande au nom de la demanderesse déposé le même jour, impose la même fréquence de rafraîchissement pour l'ensemble des groupes de cellules-mémoire, par exemple l'ensemble des pages-mémoire de la mémoire. Par conséquent, un seul groupe de cellules-mémoire défectueux peut influer sur la fréquence de rafraîchissement de l'ensemble de la mémoire.

Le Brevet US-2004-218439 décrit un rafraichissement d'une mémoire de type DRAM. La mémoire est organisée en page-mémoire. La mémoire comprend une mémoire statique SRAM organisée en N mots, N correspondant au nom de pages-mémoires précédemment cité. Chaque mot indique si une page est faible et potentiellement l'état de son rafraichissement. Le Brevet US-2005-0030806 décrit la mémoire vive dynamique du préambule de la revendication 1. Les documents US-6094705, US 4 292 676 et US 6 167 484 décrivent une unique indication d'accès par groupe.

L'invention vise à apporter une solution à ces différents problèmes.

Différents aspects et modes de mise en oeuvre de l'invention sont définis dans les revendications.

Un but de l'invention est de proposer un procédé de rafraîchissement de mémoire vive dynamique dans lequel le faible temps de rétention d'une cellule-mémoire ne se répercute pas sur la fréquence de rafraîchissement des autres cellules-mémoire de la mémoire.

Un autre but de l'invention est de proposer un procédé de rafraîchissement de mémoire vive dynamique, dans lequel on peut adapter le rafraîchissement de la mémoire et donc la consommation liée à ce rafraîchissement.

Un autre but de l'invention est de pouvoir adapter le rafraîchissement de la mémoire même dans le cas du mode de fonctionnement actif de l'appareil incorporant de la mémoire vive.

Selon un premier aspect de l'invention il est proposé une mémoire vive dynamique comprenant des groupes de cellules mémoire. Selon une caractéristique générale de ce premier aspect de l'invention ladite mémoire comprend une mémoire auxiliaire par groupe de cellules, stockant des informations de rafraîchissement spécifiques au groupe de cellules.

En d'autres termes, la mémoire vive dynamique comprend une mémoire auxiliaire qui permet de gérer des informations de rafraîchissement pour chaque groupe de cellules, indépendamment des autres.

Ainsi, chaque groupe de cellules mémoire bénéficiant de sa propre information de rafraîchissement, on peut avantageusement modifier ces informations sans affecter les informations de rafraîchissement des autres groupes de cellules-mémoire.

De préférence, les informations de rafraîchissement comprennent une période de rafraîchissement courante et un temps restant avant rafraîchissement.

Par conséquent, il est possible (par exemple) de conserver une période de rafraîchissement relativement importante, mais permettant un rafraîchissement suffisant pour une grande partie des groupes de cellules-mémoire (par exemple), et donc diminuer la consommation de la mémoire. Par ailleurs, pour les groupes de cellules-mémoires ayant un temps de rétention relativement faible, on peut mémoriser au sein de la mémoire auxiliaire correspondante une période de rafraîchissement plus faible.

En outre, la mémorisation du temps restant avant rafraîchissement permet de savoir à quel moment devra être effectué le prochain rafraîchissement.

Selon un mode de réalisation, les informations de rafraîchissement comprennent en outre une indication d'accès en lecture et une indication d'accès en écriture, et un circuit logique apte à mettre à jour les indications d'accès selon que le groupe de cellules associé a été accédé en lecture ou en écriture au cours d'une période de rafraîchissement courante.

En d'autres termes, le rafraîchissement des groupes de cellules-mémoire tient compte des éventuels accès à la mémoire. Ainsi par exemple, à partir des informations de rafraîchissement et des indications d'accès, on peut ne pas rafraîchir les pages qui ont été récemment accédées.

En effet, les accès aux données étant destructifs, une réécriture (et donc un rafraîchissement) des données a systématiquement lieu après chaque accès. Par conséquent, on limite le nombre de rafraîchissements à réaliser par cycle de balayage, comme expliqué plus en détail ci-après, ce qui entraîne une baisse importante de la consommation de la mémoire.

De plus, étant donné que l'invention tient compte des éventuels accès à la mémoire, il est possible d'utiliser l'invention au cours du fonctionnement actif de l'appareil incorporant la mémoire.

En réduisant la fréquence de rafraîchissement en mode de fonctionnement actif, on réduit l'impact du rafraîchissement sur la bande passante utile, c'est-à-dire, que l'on augmente le nombre d'accès mémoire disponibles pour l'utilisateur par unité de temps, ce qui accroît les performances du système incorporant l'invention.

La mémoire telle que mentionnée ci-dessus peut être incorporée dans un appareil possédant un mode de veille et un mode de fonctionnement actif. Cet appareil peut former un composant d'un système de communication sans fil, par exemple, un téléphone mobile cellulaire.

Selon un autre aspect de l'invention, il est proposé un procédé de rafraîchissement d'une mémoire telle que mentionnée ci-avant. Selon une caractéristique générale de cet autre aspect de l'invention, ledit procédé comprend les étapes suivantes :
- balayer les mémoires auxiliaires des groupes de cellules en décrémentant le temps restant ; et
- si le temps restant est nul, rafraîchir le groupe de cellules associé et réinitialiser le temps restant à la valeur de la période de rafraîchissement courante.

Selon un mode de mise en oeuvre, ledit procédé comprend en outre l'étape suivante :
- si un accès en lecture au groupe de cellules a eu lieu, augmenter le temps restant qui lui est associé.

De préférence, ledit procédé comprend en outre l'étape suivante :
- si un accès en écriture au groupe de cellules a eu lieu, réinitialiser sa période de rafraîchissement courante à une valeur minimale et annuler le temps restant qui lui est associé.

Le temps restant peut être réinitialisé à la période de rafraîchissement courante moins la période du balayage.

Selon un autre mode de mise en oeuvre, ledit procédé, comprend les étapes suivantes faisant partie d'un test de rétention (de façon à déterminer le temps de rétention de chaque groupe de cellules-mémoire) :
- sauvegarder le contenu d'un groupe de cellules dont on teste la rétention dans une mémoire temporaire ;
- augmenter le temps restant associé ;
- à l'expiration du temps restant, comparer le contenu du groupe de cellules au contenu de la mémoire temporaire ;
- s'il y a égalité ou une différence corrigible (grâce à un système de correction d'erreur classiquement couplé à la mémoire vive), augmenter la période de rafraîchissement courante associée; et
- s'il y a une différence non corrigible, diminuer la période de rafraîchissement courante associée et restaurer le contenu de la mémoire temporaire dans le groupe de cellules testé.

Autrement dit, la période de rafraîchissement est diminuée seulement s'il y a un risque d'erreur non corrigible.

De préférence ledit procédé comprend en outre l'étape suivante :
- si un accès en écriture a eu lieu lors du test de rétention, réinitialiser la période de rafraîchissement courante du groupe de cellules à une valeur minimale et annuler le temps restant qui lui est associé.

D'autres avantages et caractéristiques de l'invention apparaîtront à l'examen de la description détaillée d'un mode de mise en oeuvre et de réalisation, nullement limitatif, et des dessins annexés, sur lesquels :
- la figure 1 illustre très schématiquement une mémoire vive selon l'invention au sein de laquelle les cellules-mémoire sont successivement regroupées en ligne ;
- la figure 2 illustre plus en détail mais toujours schématiquement, un dispositif de mémoire selon l'invention et plus particulièrement les moyens supplémentaires de traitement et les moyens de test associés à la mémoire vive selon l'invention ; et
- la figure 3 représente un organigramme schématique d'un mode de mise en oeuvre du procédé selon l'invention.

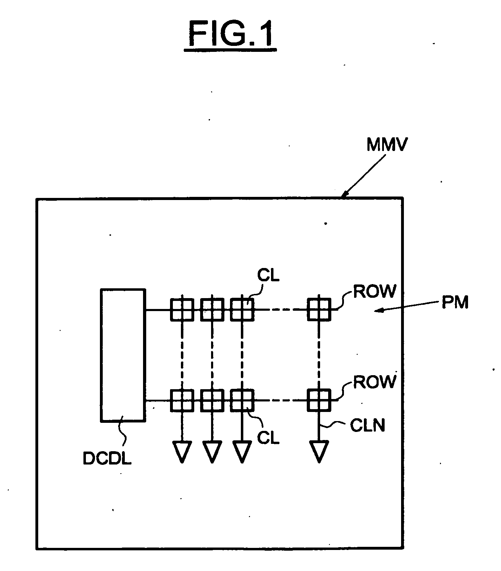

Sur la figure 1, la référence MMV désigne une mémoire vive dynamique selon l'invention dont le plan mémoire PM comporte un réseau matriciel de cellules-mémoire CL typiquement organisé en rangées (lignes ROW) et en colonnes (CLN). Chaque cellule-mémoire comporte généralement un transistor et un condensateur.

Par ailleurs, de façon classique et connue en soi, le plan mémoire PM est connecté à un décodeur ligne DCDL et à un décodeur colonne (non représenté ici à des fins de simplification).

D'une manière générale, selon l'invention, on mesure continuellement et dynamiquement sur la puce (circuit intégré) contenant la mémoire MMV le temps de rétention de toutes les cellules de la mémoire, et on va ajuster la période de rafraîchissement des cellules-mémoire de cette mémoire en conséquence.

Dans l'exemple décrit ici, la mémoire est organisée en pages-mémoire, une page correspondant à une ligne de mots.

On peut d'ores et déjà décrire les grandes lignes d'un mode de mise en oeuvre du procédé selon l'invention avant d'y revenir plus en détail par la suite.

Les adresses de la mémoire vive dynamique à rafraîchir sont continuellement balayées à une fréquence de balayage, que ce soit en mode veille ou en mode de fonctionnement actif.

Au cours du cycle de balayage, pour chaque groupe de cellules-mémoire (dans cet exemple, une page), on détecte si un accès a été effectué par l'utilisateur, lors de la période de balayage précédente.

Selon l'invention, chaque groupe de cellules-mémoire (ou chaque page) dispose d'une fréquence de rafraîchissement qui lui est propre, cette fréquence étant un multiple de la fréquence de balayage de la mémoire.

La fréquence de rafraîchissement de chaque page est déterminée à l'aide d'un test de rétention dont on donnera un mode de réalisation détaillé ci-après. Dans cet exemple, on considèrera que le test de rétention tient compte du contenu de la page-mémoire pour déterminer sa fréquence de rafraîchissement.

Un rafraîchissement d'une page mémoire est jugé nécessaire si une durée correspondant à la période de rafraîchissement de la page considérée, est expirée,

Si un accès en lecture a été réalisé durant la dernière période de balayage, on retarde alors le rafraîchissement de la page en question, d'une durée égale à la période de rafraîchissement de celle-ci, minorée d'une période de balayage. En effet, dans une mémoire vive dynamique, la lecture des données est destructive, c'est-à-dire qu'à l'issue de la lecture d'une donnée, celle-ci doit être réécrite. Par conséquent, la lecture d'une donnée est systématiquement suivie par un rafraîchissement de sa valeur. Il n'est donc pas nécessaire de procéder à un rafraîchissement supplémentaire de la page mémoire venant d'être lue.

Dans le cas où le test de rétention tient compte du contenu de la page, si un accès en écriture a été effectué par un utilisateur dans la période de balayage précédente, on affecte à la fréquence de rafraîchissement de la page considérée, sa valeur maximale, et on retarde le rafraîchissement de la page-mémoire en question d'une durée égale à sa nouvelle période de rafraîchissement minorée d'une période de balayage. En effet, les données venant d'être écrites, il n'est pas nécessaire de la rafraîchir. Cependant, la fréquence de rafraîchissement qui était affectée à la page considérée, n'est plus valide, étant donné que les données mémorisées par cette page ont changé. On considère alors, par sécurité, que l'on se retrouve dans le pire cas. Et pour éviter toutes pertes de données, la fréquence de rafraîchissement de la page considérée est mise à sa valeur maximale.

Plus généralement, si le test de rétention détermine pour une page donnée, une période de rafraîchissement indépendante de son contenu, il n'y a pas lieu de distinguer un accès en lecture d'un accès en écriture. Dans ce cas, s'il y a un accès à la mémoire, quel que soit le type d'accès à la mémoire, le rafraîchissement est retardé de la même durée, de préférence d'une durée égale à la période de rafraîchissement de la page-mémoire, minorée d'une période de balayage.

Par contre, si aucun accès utilisateur n'a été détecté lors de la période de balayage précédente et que la période de rafraîchissement est écoulée, la page-mémoire en question est effectivement rafraîchie.

En outre, parallèlement au balayage de la mémoire effectué pour son rafraîchissement, un test est effectué sur chaque page de cellules-mémoire, pour ajuster sa fréquence de rafraîchissement à une valeur optimale.

Par exemple, le test peut consister pour chaque page testée, à ne pas la rafraîchir pendant plusieurs périodes puis à comptabiliser les erreurs apparues. Si aucune erreur ne survient, on diminue alors la fréquence de rafraîchissement de la page testée. A l'inverse, si des erreurs surviennent, on agit sur la fréquence de rafraîchissement de la page-mémoire en question.

En outre, comme déjà mentionnée ci-avant, un code correcteur d'erreur (ECC) (par exemple le code de Hamming, bien connu de l'homme du métier, dont une version est décrite sur le site : **http://burtleburtle.net/bob/math/errorcorr.htlm),** permet la correction d'un bit par paquet de cellules-mémoire.

Le code correcteur d'erreur consiste en des bits supplémentaires ajoutés à chaque mot lors de leur écriture dans la mémoire. Ces bits supplémentaires sont traités lorsque le mot est lu, de façon à détecter et corriger k éventuelles erreurs par mot (par exemple 1 erreur par mot).

Par conséquent, lors du test de rétention, il est possible de prendre en compte le nombre d'erreurs uniquement si celui-ci est supérieur ou égal à k au sein d'un même paquet (mot), k étant le nombre d'erreurs que le code correcteur d'erreurs permet de corriger. En effet, s'il existe k erreurs ou moins au sein d'un paquet (mots) de cellules-mémoire, celles-ci seront corrigées du fait de l'existence du code correcteur d'erreurs. Il n'est donc pas nécessaire de modifier la fréquence de rafraîchissement pour prévenir l'apparition de ces erreurs. Dans la suite du texte, sauf indication contraire, k est égal à 1.

On répète l'opération de test sur toute la mémoire, en changeant à chaque fois de page de test.

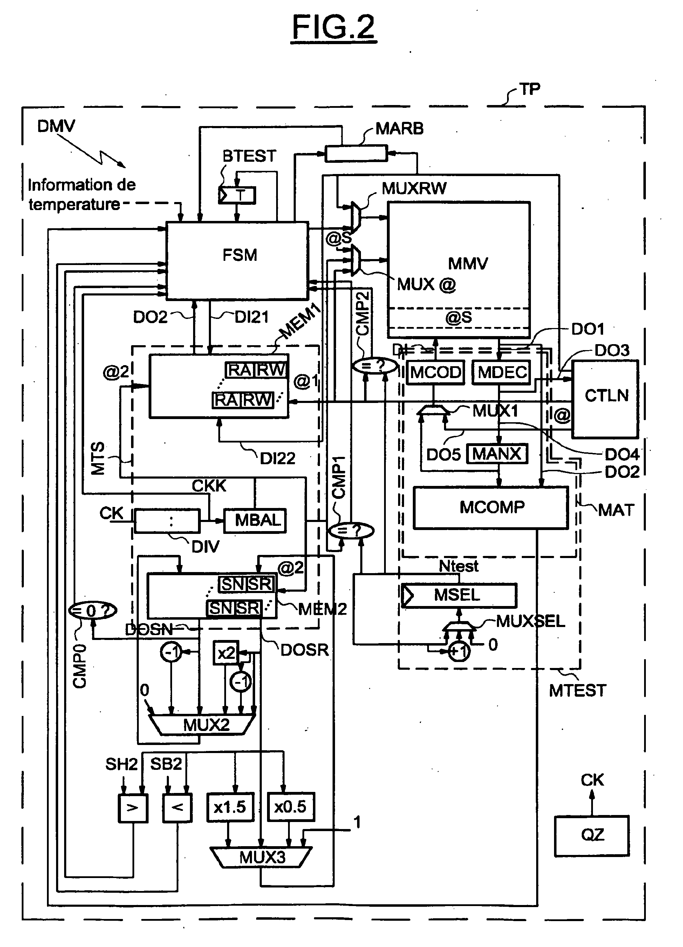

On se réfère à présent à la figure 2, illustrant plus en détail un dispositif de mémoire référencé DMV selon l'invention.

Afin de mettre en oeuvre le mécanisme de rafraîchissement de la mémoire vive MMV, ainsi que la régulation de la fréquence de rafraîchissement, le dispositif de mémoire DMV, comporte notamment, outre la mémoire MMV, des moyens de traitement supplémentaires MTS dont on va maintenant décrire plus en détail un mode de réalisation.

Les moyens MTS comprennent des moyens de rafraîchissement qui sont, dans cet exemple, formés par une partie des moyens de commande FSM (représentés à l'extérieur du trait discontinu) aptes à commander le rafraîchissement de la mémoire MMV.

Pour contrôler le rafraîchissement de la mémoire MMV, les moyens MTS comprennent des moyens de détection MEM 1 formés dans cet exemple par une mémoire de préférence statique, et de préférence de type à double-port.

La mémoire MEM1 est apte à stocker autant de mots que de pages contenues dans la mémoire MMV. Chaque mot comprend notamment deux bits RA et RW d'indication d'accès, aptes respectivement à indiquer l'occurrence d'un accès en lecture ou en écriture (RA= « 1 ») et un accès en écriture (RW= « 1 »).

La mémoire MEM1 est connectée aux moyens de commande FSM par l'intermédiaire de deux bus, un bus de sortie DO2 et un bus d'entrée DI21.

Le bus DO2 permet de délivrer, pour une page-mémoire considérée, la valeur des bits RA et RW.

L'adresse de la page-mémoire à considérer est délivrée à la mémoire MEM1, par un bus d'adresse @2.

La mémoire MEM1 est également connectée à un contrôleur classique CTLN dédié au fonctionnement actif du dispositif DMV.

Lorsqu'un accès utilisateur survient au cours du fonctionnement actif, le contrôleur CTLN envoie les nouvelles valeurs des bits RA et RW à la mémoire MEM1 via un bus de données DI22 ainsi que l'adresse de la page accédée par un bus d'adresses @1.

Les moyens MTS comprennent également des moyens de balayage MBAL qui reçoivent un signal d'horloge CK, divisé par un diviseur DIV, de façon que le signal CKK délivré en entrée des moyens de balayage, ait pour fréquence la fréquence de balayage.

Ainsi, à partir du signal CKK et du nombre total Nmax de pages-mémoire de la mémoire MMV, les moyens MBAL délivrent successivement les adresses des pages-mémoire de la mémoire, via le bus @2.

Le signal d'horloge CK est par exemple généré par un oscillateur à quartz QZ.

Les moyens MTS comprennent également des moyens de retard comportant dans cet exemple une mémoire de type mémoire statique, de préférence à simple port, référencé MEM2.

Dans un autre mode de réalisation, il serait possible de regrouper les mémoires MEM1 et MEM2 dans une seule mémoire à double port.

De même que pour la mémoire MEM1, la mémoire MEM2 comprend autant de mots que de pages dans la mémoire MMV.

Chaque mot de la mémoire MEM2 comporte notamment, deux informations de rafraîchissement SN et SR. L'information SR indique la valeur courante de la période de rafraîchissement d'une page donnée.

Ainsi, chaque mot de la mémoire MEM2 correspond à une mémoire auxiliaire mentionnée ci-avant.

L'information SN indique le temps restant avant le prochain rafraîchissement de la page considérée. Ce temps restant est exprimé en fonction d'une unité de temps de référence, ce temps de référence correspondant par exemple à la période de balayage.

La mémoire MEM2 est connectée au moyen de balayage MBAL par l'intermédiaire du bus d'adresse @2, de façon à recevoir pour chaque cycle de balayage l'adresse de la page-mémoire désignée.

Par ailleurs, la valeur de l'information SN est délivrée en sortie de la mémoire MEM2 par un bus de sortie DOSN vers un comparateur CMP0. Si la valeur de SN est nulle, alors le comparateur CMP0 délivre une information aux moyens de commande FSM, pour rafraîchir la page à l'adresse désignée par les moyens de balayage MBAL.

Lorsqu'une page-mémoire de la mémoire MMV doit être rafraîchie, les moyens de commande FSM délivrent à la mémoire MMV une commande de rafraîchissement à l'adresse de la page à rafraîchir, respectivement via un multiplexeur MUXRW et un multiplexeur MUX@.

Si un accès utilisateur a lieu, le contrôleur CTLN envoie l'adresse de la page accédée, la commande de lecture ou d'écriture, et les données à écrire (dans le cas d'une écriture), respectivement via les multiplexeurs MUX@, MUX RW, et MUX1.

Par ailleurs, le dispositif de mémoire vive DMV comprend des moyens de test MTEST, de façon à optimiser la fréquence de rafraîchissement de chaque page-mémoire de la mémoire.

Un mode de réalisation des moyens de test MTEST est décrit plus en détail dans la demande de brevet précitée, déposée le même jour au nom de la demanderesse.

Ce mode de réalisation est représenté sur cette figure. Cependant, il est possible d'implémenter tout autre mode de réalisation compatible avec le dispositif de mémoire vive dynamique, par exemple les moyens de test décrits dans la demande N° 0301005 au nom de la demanderesse.

Dans cet exemple, le mode de mise en oeuvre implémenté par les moyens de test MTEST consiste à rafraîchir moins vite, par exemple deux fois moins vite que les pages restantes, une page-mémoire sélectionnée qualifiée de page de test, et d'observer si cela provoque des erreurs ou non.

On répète l'opération sur toute la mémoire en changeant à chaque fois de page de test. L'apparition d'erreurs dans le contenu non rafraîchi pendant deux périodes, indique que la valeur de la fréquence de rafraîchissement est trop faible.

Plus précisément, avant de rafraîchir moins vite une page de test, on élabore un contenu modèle de la page de test. Pour ce faire, on sauvegarde dans une partie réservée de la mémoire vive ou dans une mémoire statique annexe, pendant une période de latence, le contenu de la page de test, que l'on rafraîchit à la fréquence maximale de rafraîchissement. De cette façon, on prévient les erreurs liées aux fuites de jonction.

Pour ce faire, les moyens de test MTEST comprennent des moyens de sélection MSEL balayant chaque page de la mémoire successivement et cycliquement, de façon à tester une à une chaque page-mémoire de la mémoire MMV.

Ils délivrent alors une adresse Ntest d'une page-mémoire sélectionnée, autrement dit une page de test.

Les moyens de sélection MSEL sont commandés par les moyens de commande FSM par l'intermédiaire d'un multiplexeur MUXSEL connecté à leur entrée. Selon la commande des moyens FSM, les moyens de sélection MSEL peuvent être soit remis à zéro, soit incrémentés d'une unité, soit maintenus à leur valeur en cours.

Une page de test n'est pas rafraîchie par les moyens de commande FSM. Pour cela, le dispositif DMV comprend un comparateur CMP1 recevant en entrée les adresses délivrées sur le bus @2 et Ntest. Si les deux adresses correspondent, les moyens de commande FSM passent le rafraîchissement de la page-mémoire.

Le temps de rétention des cellules-mémoire de la page de test sélectionnée est testé par les moyens de test MTEST, sous réserve d'un accès en écriture de la page de test, comme on le verra ci-après. Ces derniers comprennent des moyens de décodage MDEC (formant un système de correction d'erreur) connectés à la sortie de la mémoire vive MMV par l'intermédiaire d'un bus de sortie DO1. Les moyens de décodage MDEC permettent de corriger les erreurs éventuelles des données de la mémoire grâce à l'utilisation des bits supplémentaires constituant le code correcteur d'erreur implémenté au sein du dispositif de mémoire comme mentionné ci-avant.

Les moyens de décodage MDEC traitent les données délivrées par le bus DO1.

On considère dans cet exemple que le contenu modèle de la page de test est sauvegardée dans une partie réservée de la mémoire

MMV (ou mémoire temporaire), d'adresse @S, que l'utilisateur n'a pas le droit d'utiliser.

La partie réservée de la mémoire MMV, d'adresse @S, sert à sauvegarder le contenu modèle de la page de test, tel que décrit ci-avant.

La partie réservée d'adresse @S de la mémoire, peut par exemple être rafraîchie à la fréquence maximale de rafraîchissement , ou peut être rafraîchie à sa propre fréquence de rafraîchissement mais testée prioritairement.

La sortie des moyens de décodage MDEC est reliée à un registre MANX par l'intermédiaire d'un bus DO4.

Le registre MANX est commandé par les moyens de commande FSM.

Le registre MANX reçoit la page de test sauvegardée mot par mot pour pouvoir effectuer la comparaison avec le mot testé, rafraîchi à une fréquence plus faible.

En variante, la taille du registre MANX peut être adaptée pour pouvoir recevoir plusieurs mots (ou encore toute la page de test sauvegardée), notamment dans le cas où la lecture est effectuée selon le mode dit « Rafale », (« Burst » en langue anglaise), c'est-à-dire lorsque plusieurs mots d'une même page sont lus successivement.

La sortie du registre MANX est connectée à des moyens de comparaison bit-à-bit MCOMP. Ces derniers reçoivent également en parallèle les données de la page de test non rafraîchie pendant la période de latence, directement délivrées en sortie de la mémoire MMV par le bus DO1. (A titre d'exemple, des modes de réalisation détaillés des moyens de comparaison sont décrits dans la demande au nom de la demanderesse déposée le même jour, déjà citée). La comparaison peut également être réalisée en mode « Burst ».

Les moyens de comparaison bit-à-bit MCOMP comparent le contenu du registre MANX, c'est-à-dire la page mémoire modèle, et les données délivrées par le bus DO1, c'est-à-dire les données non corrigées et non rafraîchies pendant la période de latence, de la page-mémoire correspondante.

Si les moyens de comparaison MCOMP (formant des moyens de repérage) repèrent au plus 1 bit ayant une valeur différente entre le contenu modèle et le contenu non rafraîchi (i bits dans le cas général, avec i≤k, si le code correcteur implémenté dans le système peuvent corriger k erreurs), celle-ci n'est pas prise en compte, car les moyens de décodage MDEC pourront la corriger (à l'aide du code correcteur ajouté aux données) lorsque les données de la page mémoire en question seront délivrées hors de la mémoire.

Les moyens de commande FSM commandent alors une légère diminution de la fréquence de rafraîchissement de la page de test.

Par contre, s'il existe plus d'une erreur, les moyens de commande FSM commandent alors une légère augmentation de la fréquence de rafraîchissement de la page de test.

Pour contrôler la fréquence de rafraîchissement, les moyens de commande FSM contrôlent un multiplexeur MUX3 connecté par un bus DOSR à la mémoire MEM2 et dont la sortie est rebouclée sur la mémoire MEM2.

Le multiplexeur MUX3 reçoit en entrée la valeur courante de SR, sa valeur minimale (« 1 »), sa valeur augmentée (ici multipliée par 1.5) et sa valeur diminuée (ici multipliée par 0.5).

Si la période de rafraîchissement doit être diminuée, les moyens de commande FSM commandent la délivrance de la valeur courante de SR multipliée par 0.5 (cette valeur est donnée à titre indicatif).

Si la période de rafraîchissement doit être augmentée, les moyens de commande FSM commandent la délivrance de la valeur courante de SR multipliée par 1.5 (cette valeur est donnée à titre indicatif).

Si la fréquence de rafraîchissement est inchangée, les moyens de commande FSM commandent la délivrance de la valeur courante de SR.

Par ailleurs, la valeur de SR doit être comprise entre deux seuils, respectivement bas SB2 et haut SH2. Pour ce faire, la valeur de SR est délivrée à deux comparateurs, la comparant respectivement à chacun de ses seuils. La sortie de ces deux comparateurs est connectée au moyen de commande FSM qui régule la valeur de SR, si celle-ci n'est plus comprise dans la plage qui lui est assignée.

Ce mode de réalisation est donné à titre indicatif. Par exemple, au lieu de multiplier la fréquence de rafraîchissement par une constante, il est possible d'ajouter ou de retrancher une valeur pour augmenter ou diminuer la fréquence de rafraîchissement.

Par ailleurs les moyens de commande FSM commandent un multiplexeur MUX2, connecté par un bus de données DOSN à la mémoire MEM2, et dont la sortie est rebouclée sur l'entrée de la mémoire MEM2.

En commandant le multiplexeur MUX2, les moyens de commande FSM ajustent la valeur de l'information SN pour déclencher le rafraîchissement au moment approprié.

Les moyens de commande FSM peuvent ainsi décrémenter, remettre à sa valeur initiale ou affecter la valeur de la période de latence ou sa valeur minimale, à l'information SN.

A cet effet, le multiplexeur MUX2 reçoit en entrée, la valeur courante de l'information SN par le bus de données DOSN, la valeur de SN décrémentée d'une unité à chaque cycle de balayage de la mémoire MMV, la valeur de 0 de façon à forcer l'information SN à sa valeur minimale pour provoquer un rafraîchissement au prochain cycle de balayage de la mémoire, une valeur égale au double de l'information SR pour ne pas rafraîchir la page-mémoire en cours de test pendant une période de latence égale, dans cet exemple, à deux fois la valeur de SR, la valeur de SR décrémentée d'une unité, SR-1, dans le cas où un accès en lecture a été fait par l'utilisateur lors du précédent cycle de balayage et directement l'information SR lorsqu'on veut réinitialiser l'information SN à la valeur courante de la période de rafraîchissement de la page-mémoire considérée.

La sortie de la mémoire MEM2 est connectée au comparateur CMP0 via le bus DOSN pour vérifier si la valeur de SN est nulle, comme détaillé ci-avant.

De plus, le contrôleur CTLN est connecté aux moyens de décodage MDEC via le bus DO3, lorsque des données sont lues en mode de fonctionnement actif.

Ainsi, lorsqu'une donnée est lue, son éventuelle erreur est détectée et corrigée par les moyens de décodage MDEC.

Par ailleurs, en fonctionnement actif, le contrôleur CTLN délivre par un bus DO5, les données à écrire dans la mémoire via un multiplexeur MUX1 connecté en entrée de moyens de codage MCOD.

Le multiplexeur MUX1 est également connecté à la sortie du registre MANX de façon à recevoir la page-mémoire modèle à l'issue de la comparaison effectuée par les moyens de comparaison MCOMP, en remplacement de la page de test qui n'a pas été rafraîchie pendant une période de latence et qui peut donc avoir des erreurs.

Le multiplexeur MUX1 est commandé par les moyens de commande FSM de façon à délivrer, soit la page-mémoire modèle qui doit être réécrite dans la mémoire MMV, soit les données à écrire lors d'un accès utilisateur.

Les données délivrées par le multiplexeur MUX1 sont encodées par les moyens de codage MCOD avant d'être écrites dans la mémoire MMV. Ainsi, les moyens MCOD génèrent des bits supplémentaires constituant le code correcteur pour chaque mot délivré par le multiplexeur MUX1 puis écrit dans la mémoire MMV.

En variante, il est possible de n'écrire dans la mémoire que les mots où les moyens MCOMP ont détecté au moins une erreur.

Le dispositif de mémoire comprend également un comparateur CMP2, connecté en sortie du contrôleur CTLN et des moyens de sélection MSEL.

Si l'adresse Ntest de la page-mémoire en cours de test est accédée par l'utilisateur, un signal est délivré par le comparateur CMP2 aux moyens de commandes FSM.

Les moyens de commande FSM vont alors forcer l'accès utilisateur vers la zone réservée d'adresse @S de la mémoire MMV, qui stocke la page mémoire modèle et non le contenu de la page-mémoire en cours de test.

Pour ce faire, le multiplexeur MUX@ comprend une entrée sur laquelle est délivrée l'adresse @S de la zone réservée.

En outre, le dispositif DMV comprend des moyens d'arbitrage MARB dont une entrée est connectée aux moyens de commande FSM et une autre entrée est connectée au contrôleur CTLN dédié au fonctionnement actif.

Les moyens d'arbitrage MARB permettent d'ordonner le rafraîchissement et l'accès utilisateur selon une priorité choisie.

De préférence, les moyens d'arbitrage MARB autorisent le rafraîchissement de la page-mémoire et permettent, après un temps d'attente (« wait-state », en langue anglaise), l'accès utilisateur.

A cet effet, en fonction des informations délivrées par les moyens d'arbitrage MARB, les moyens de commande FSM peuvent piloter les multiplexeurs MUX@, MUXRW, et MUX1 de façon à envoyer l'adresse, la commande, et la donnée en provenance du contrôleur CTLN ou du système de rafraîchissement selon une priorité choisie.

Les moyens de commande FSM reçoivent également en entrée l'information de température, de façon à forcer l'augmentation de la fréquence de rafraîchissement de chaque page-mémoire en cas d'une variation très rapide de la température.

Cette information comporte une indication de variation rapide de température, et permet d'anticiper des pertes de données résultant d'une élévation rapide de température.

Par ailleurs, de façon à indiquer si une page de la mémoire est en test, une bascule BTEST rebouclée sur les moyens de commande FSM stocke une variable T prenant la valeur « 1 » si la page indiquée par les moyens de sélection MSEL est en cours de test.

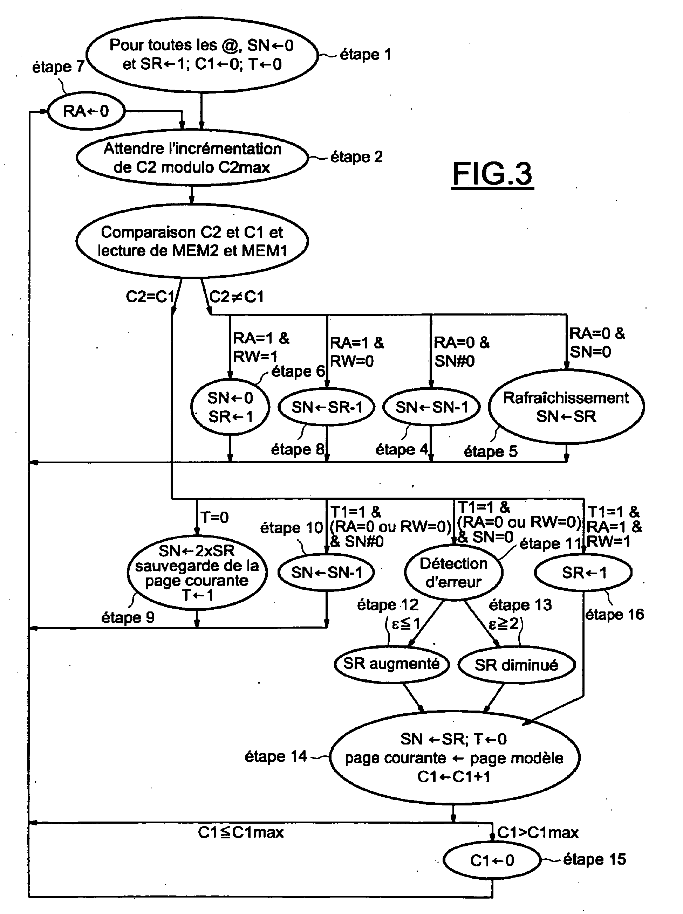

On se réfère à présent plus particulièrement à la figure 3, qui représente un organigramme décrivant les différents états des moyens de commande FSM qui peuvent être réalisés sous la forme d'une machine à état fini.

Sur la figure 3, les références C1 et C2 désignent les adresses délivrées respectivement par les moyens de sélection MSEL et les moyens de balayage MBAL.

La variable T indique si le test de la page de test considérée est en cours ; dans ce cas T= « 1 ».

Lors d'une première étape d'initialisation, les informations SN et SR sont respectivement mises à « 0 » et « 1 », de façon à affecter par défaut la fréquence de rafraîchissement maximale (SR=1), et à provoquer un rafraîchissement dès le premier cycle de balayage (SN=0).

En outre, le compteur C1 est initialisé, ainsi que la variable T (étape 1 ; pour toutes les @, SN<-0 et SR<-2 ; C1<-0, et T<-0).

La valeur du compteur C2 est quant à elle gérée par le diviseur DIV.

Au cours d'une deuxième étape, on attend l'incrémentation du compteur C2 (modulo C2max) de façon à désigner la première page mémoire à traiter de la mémoire MMV (plus généralement de façon à désigner une page déterminée de la mémoire) (étape 2, « Attendre l'incrémentation de C2 modulo C2max »).

On compare alors la valeur du compteur C2 et du compteur C1 et on lit le contenu des mémoires MEM2 et MEM1 (étape 3; comparaison C2 et C1 et lecture MEM2 et MEM1).

Si l'adresse désignée par le compteur C2 est différente de celle désignée par le compteur C1 (C2≠C1), on étudie la valeur des informations SN, RA et RW.

Si RA est égal à 0, et SN est différent de 0, on ne procède pas au rafraîchissement de la page-mémoire désignée par le compteur C2, et on décrémente l'information SN d'une unité (étape 4 ; SN←SN-1 ). Puis, on réitère les étapes 2 à 4 tant que SN est différent de 0 et que RA reste à 0.

Lorsque SN est nul (RA étant toujours égal à 0), on procède au rafraîchissement de la page-mémoire en question et on réaffecte à SN sa valeur maximale courante (étape 5 ; rafraîchissement, SN<-SR).

Si les bit RA et RW sont égaux à « 1 », cela signifie qu'il y a eu un accès de la mémoire par l'utilisateur, et que cet accès était un accès en écriture.

Au cours d'une étape 6, on affecte alors à SR sa valeur minimale et à SN la valeur de SR minoré de 1 (c'est-à-dire 0 dans ce cas), pour prévenir le cas où l'accès en écriture a eu lieu au tout début de la période (SN←0 ; SR←1). En d'autres termes, on affecte à la page-mémoire en question une période de rafraîchissement minimale (SR←1), car on estime que les nouvelles données écrites dans la page-mémoire correspondent aux pires cas, c'est-à-dire que toutes les cellules-mémoire ont un temps de rétention minimum, et qu'elles doivent sauvegarder un bit égal à « 1 ».

En affectant à la variable SN la valeur de 0, un rafraîchissement de la page-mémoire sera effectué au prochain cycle de balayage.

A l'issue de l'étape 6, on remet RA à « 0 » (étape 7 ; RA<-0), et on se reporte à l'étape 2.

Dans cet exemple l'étape 7 est également mise en oeuvre après les étapes 4 et 5, mais elle est sans influence puisque RA est déjà égal à 0 après chacune de ces deux étapes.

Si les variables RA et RW indiquent qu'il y a eu un accès en lecture (RA=1 & RW=0), on affecte à la variable SN la valeur de SR minorée de un intervalle, car l'accès a pu avoir lieu au tout début de la période (SN←SR-1 ; étape 8). En effet, la lecture étant destructive, toutes les données ont été réécrites à l'issue de cette lecture, ce qui rend le rafraîchissement non nécessaire.

A l'issue de l'étape 8, on se reporte à nouveau à l'étape 2, via l'étape 7 où RA est remis à 0.

Si, à l'issue de l'étape 3, l'adresse désignée par le compteur C2 correspond à l'adresse désignée par l'adresse du compteur C1 (C2=C1), on étudie la valeur de la variable T.

Si la variable T est égale à 0, signifiant que le test de la page-mémoire considérée n'est pas encore commencé, on débute le test, en affectant à la variable SN la valeur de la période de latence, dans cet exemple deux fois la valeur de la variable SR, et la valeur 1 à la variable T. On sauvegarde la page de test : c'est la page modèle pour la page de test correspondante (SN←2.SR, sauvegarde de la page courante, T←1, étape 9).

A l'issue de l'étape 9, on se reporte à nouveau à l'étape 2, via l'étape 7.

Si, à l'issue de l'étape 3, l'adresse désignée par C2 correspond à l'adresse désignée par C1, et la variable T est à 1, aucun accès utilisateur en écriture n'ayant eu lieu (RA=0 ou RW=0) et que la variable SN est différente de 0, alors on décrémente SN sans procéder au rafraîchissement, de façon à ne pas perturber la phase de test en cours (SN←SN-1 ;étape 10).

On ne tient pas compte des accès en lecture de la mémoire qui ont pu avoir lieu pendant la période de latence : en effet, ces accès sont redirigés vers la page de sauvegarde stockée dans la mémoire annexe, et ne rafraîchissent donc pas la page en cours de test.

Par contre, si SN est nul, indiquant que la période de latence s'est écoulée, on procède au cours d'une étape 11 à la détection des erreurs entre le contenu modèle et le contenu non rafraîchi de la page-mémoire en cours de test, comme explicité ci-avant.

Si le nombre maximal d'erreurs par mot (ε) est inférieur ou égal à 1 (ε≤1), on procède à l'augmentation de la période de rafraîchissement de la page considérée (étape 12 ; SR augmenté).

S'il existe plus d'une erreur dans au moins un mot de la page de test (ε ≥ 2), on diminue la période de rafraîchissement de la page considérée (étape 13, SR diminué).

Puis on remet à zéro la variable T, on remet à sa valeur maximale la variable SN, on charge la valeur de la page modèle dans la page courante de la mémoire MMV, et on incrémente le compteur C1 (étape 14 ; SN←SR ; T<-0, page courante <- page modèle, C1←C1+1).

Si l'adresse de la page de test n'était pas la dernière adresse de la mémoire (C1≤C1max), on se reporte à l'étape 2, via l'étape 7.

Si l'adresse de la page de test était la dernière adresse de la mémoire, (C1>C1max), on réinitialise C1 (étape 15 ; C1<-0) puis se rapporte à l'étape 2, via l'étape 7.

Lorsqu'à l'issue de l'étape 3, l'adresse désignée par C2 correspond à l'adresse désignée par C1, et qu'au cours de la période de test, un accès en écriture a eu lieu lors de la période de balayage précédente (T=1 et RA=R1 et RW=1), alors au cours d'une étape 16, on renonce à tester la page considérée, et on affecte à SR sa valeur maximale (SR<-1). On se ramène ensuite à l'étape 14.

L'invention est particulièrement intéressante dans le cas où la mémoire est utilisée de manière uniforme à fréquence élevée ou modérée mais suffisamment rapide pour que les moyens de test de rétention ne puissent pas fonctionner efficacement.

Le système de rafraîchissement n'interviendra alors pratiquement pas.

Dans le cas où la mémoire est accédée à fréquence faible, il y a de fortes chances pour que seule une petite partie de la mémoire soit utilisée. Dans ce cas, la partie non utilisée sera progressivement mise à la fréquence minimum de rafraîchissement permettant d'assurer la rétention des données. Seule la partie utilisée de la mémoire sera toujours rafraîchie, et parmi celle-ci, seules les pages qui ne sont pas utilisées fréquemment le seront à fréquence maximum.

## Revendications

1. Mémoire vive dynamique comprenant des groupes de cellules mémoire, et une mémoire auxiliaire par groupe de cellules, stockant des informations de rafraîchissement (SN, SR) spécifiques au groupe de cellules, telle que les informations de rafraîchissement comprennent une période de rafraîchissement courante (SR) et un temps restant avant rafraîchissement (SN) **caractérisée en ce que** les informations de rafraîchissement comprennent en outre une indication d'accès en lecture (RA) et une indication d'accès en écriture (RW), et **en ce que** la mémoire comprend un circuit logique apte à mettre à jour les indications d'accès selon que le groupe de cellules associé a été accédé en lecture ou en écriture au cours d'une période de rafraîchissement courante.

2. Procédé de rafraîchissement d'une mémoire selon la revendication 1, **caractérisé en ce qu'**il comprend les étapes suivantes :
- balayer les mémoires auxiliaires des groupes de cellules en décrémentant le temps restant ; et
- si le temps restant est nul, rafraîchir le groupe de cellules associé et réinitialiser le temps restant à la valeur de la période de rafraîchissement courante (étape 5).

3. Procédé de rafraîchissement selon la revendication 2, **caractérisé en ce qu'**il comprend en outre l'étape suivante :
- si un accès en lecture au groupe de cellules a eu lieu, augmenter le temps restant qui lui est associé (étape 8).

4. Procédé de rafraîchissement selon la revendication 2, **caractérisé en ce qu'**il comprend en outre l'étape suivante :
- si un accès en écriture au groupe de cellules a eu lieu, réinitialiser sa période de rafraîchissement courante à une valeur minimale et annuler le temps restant qui lui est associé (étape 6).

5. Procédé de rafraîchissement selon la revendication 3, **caractérisé en ce que** le temps restant est réinitialisé à la période de rafraîchissement courante moins la période du balayage.

6. Procédé selon la revendication 2, **caractérisé en ce qu'**il comprend les étapes suivantes faisant partie d'un test de rétention :
- sauvegarder le contenu d'un groupe de cellules dont on teste la rétention dans une mémoire temporaire (étape 9) ;
- augmenter le temps restant associé (étape 9);
- à l'expiration du temps restant, comparer le contenu du groupe de cellules au contenu de la mémoire temporaire (étape 11) ;
- s'il y a égalité ou une différence corrigible, augmenter la période de rafraîchissement courante associée (étape 12); et
- s'il y a une différence non corrigible, diminuer la période de rafraîchissement courante associée et restaurer le contenu de la mémoire temporaire dans le groupe de cellules testé (étape 13).

7. Procédé selon la revendication 6, **caractérisé en ce qu'**il comprend en outre l'étape suivante :
- si un accès en écriture a eu lieu lors du test de rétention, réinitialiser la période de rafraîchissement courante du groupe de cellules à une valeur minimale et annuler le temps restant qui lui est associé (étape 16).

## Claims

1. Dynamic random access memory comprising groups of memory cells and an auxiliary memory per group of cells, storing refresh information (SN, SR) specific to the group of cells, such that the refresh information comprises a current refresh period (SR) and a time remaining before refresh (SN), **characterized in that** the refresh information furthermore comprises an indication of read access (RA) and an indication of write access (RW) and **in that** the memory comprises a logic circuit able to update the access indications depending on whether the associated group of cells has been read accessed or write accessed in the course of a current refresh period.

2. Method of refreshing a memory according to Claim 1, **characterized in that** it comprises the following steps:
- scanning the auxiliary memories of the groups of cells while decrementing the time remaining; and
- if the time remaining is zero, refreshing the associated group of cells and reinitializing the time remaining to the value of the current refresh period (step 5).

3. Method of refreshing according to Claim 2, **characterized in that** it furthermore comprises the following step:
- if a read access to the group of cells has taken place, increasing the time remaining associated therewith (step 8).

4. Method of refreshing according to Claim 2, **characterized in that** it furthermore comprises the following step:
- if a write access to the group of cells has taken place, reinitializing its current refresh period to a minimum value and cancelling the time remaining associated therewith (step 6).

5. Method of refreshing according to Claim 3, **characterized in that** the time remaining is reinitialized to the current refresh period minus the period of the scan.

6. Method according to Claim 2, **characterized in that** it comprises the following steps forming part of a retention test:
- saving the content of a group of cells whose retention is tested in a temporary memory (step 9);
- increasing the associated time remaining (step 9);
- on expiry of the time remaining, comparing the content of the group of cells with the content of the temporary memory (step 11);
- if there is equality or a correctable difference, increasing the associated current refresh period (step 12); and
- if there is an uncorrectable difference, decreasing the associated current refresh period and restoring the content of the temporary memory into the tested group of cells (step 13).

7. Method according to Claim 6, **characterized in that** it furthermore comprises the following step:
- if a write access has taken place during the retention test, reinitializing the current refresh period of the group of cells to a minimum value and cancelling the time remaining associated therewith (step 16).

## Patentansprüche

1. Dynamischer Arbeitsspeicher, der Gruppen von Speicherzellen und einen Hilfsspeicher pro Zellengruppe enthält, der für die Zellengruppe spezifische Auffrischungsinformationen (SN, SR) speichert, derart, dass die Auffrischungsinformationen eine laufende Auffrischungsperiode (SR) und eine Restzeit vor Auffrischung (SN) enthalten, **dadurch gekennzeichnet, dass** die Auffrischungsinformationen außerdem eine Lesezugriffsanzeige (RA) und eine Schreibzugriffsanzeige (RW) enthalten, und dass der Speicher eine Logikschaltung enthält, die die Zugriffsanzeigen aktualisieren kann, je nachdem, ob auf die zugeordnete Zellengruppe während einer laufenden Auffrischungsperiode im Lese- oder im Schreibbetrieb zugegriffen wurde.

2. Verfahren zur Auffrischung eines Speichers nach Anspruch 1, **dadurch gekennzeichnet, dass** es die folgenden Schritte enthält:
- Abtasten der Hilfsspeicher der Zellengruppen, indem die Restzeit dekrementiert wird; und
- wenn die Restzeit Null ist, Auffrischen der zugeordneten Zellengruppe und neues Initialisieren der Restzeit auf den Wert der laufenden Auffrischungsperiode (Schritt 5).

3. Auffrischungsverfahren nach Anspruch 2, **dadurch gekennzeichnet, dass** es außerdem den folgenden Schritt enthält:
- wenn ein Lesezugriff auf die Zellengruppe stattgefunden hat, Erhöhen der ihr zugeordneten Restzeit (Schritt 8).

4. Auffrischungsverfahren nach Anspruch 2, **dadurch gekennzeichnet, dass** es außerdem den folgenden Schritt enthält:
- wenn ein Schreibzugriff auf die Zellengruppe stattgefunden hat, neues Initialisieren ihrer laufenden Auffrischungsperiode auf einen minimalen Wert und Annullieren der ihr zugeordneten Restzeit (Schritt 6).

5. Auffrischungsverfahren nach Anspruch 3, **dadurch gekennzeichnet, dass** die Restzeit auf die laufende Auffrischungsperiode minus die Abtastperiode neu initialisiert wird.

6. Verfahren nach Anspruch 2, **dadurch gekennzeichnet, dass** es die folgenden Schritte enthält, die Teil eines Aufbewahrungstests sind:
- Speichern des Inhalts einer Zellengruppe, deren Aufbewahrung in einem Zwischenspeicher getestet wird (Schritt 9);
- Erhöhen der zugeordneten Restzeit (Schritt 9);
- bei Ablauf der Restzeit, Vergleich des Inhalts der Zellengruppe mit dem Inhalt des Zwischenspeichers (Schritt 11);
- wenn es eine Gleichheit oder eine korrigierbare Differenz gibt, Erhöhen der zugeordneten laufenden Auffrischungsperiode (Schritt 12); und
- wenn es eine nicht korrigierbare Differenz gibt, Verringern der zugeordneten laufenden Auffrischungsperiode und Wiederherstellen des Inhalts des Zwischenspeichers in der getesteten Zellengruppe (Schritt 13).

7. Verfahren nach Anspruch 6, **dadurch gekennzeichnet, dass** es außerdem den folgenden Schritt enthält:
- wenn beim Aufbewahrungstest ein Schreibzugriff stattgefunden hat, neues Initialisieren der laufenden Auffrischungsperiode der Zellengruppe auf einen minimalen Wert und Annullieren der ihr zugeordneten Restzeit (Schritt 16).
